(19) **Europäisches Patentamt / European Patent Office / Office européen des brevets**

(11) **EP 1 885 057 B1**

(12) **FASCICULE DE BREVET EUROPEEN**

(45) Date de publication et mention
de la délivrance du brevet:
**06.05.2009 Bulletin 2009/19**

(51) Int Cl.:
***H03F 1/08*** *(2006.01)*

(21) Numéro de dépôt: **07113684.0**

(22) Date de dépôt: **02.08.2007**

(54) **Compensation en fréquence d'un amplificateur comportant au moins deux étages de gain**

Frequenzkompensation eines Verstärkers mit wenigstens zwei Verstärkungsstufen

Frequency compensation of an amplifier including at least two gain stages

(84) Etats contractants désignés:
**DE FR GB IT**

(30) Priorité: **04.08.2006 FR 0653299**

(43) Date de publication de la demande:
**06.02.2008 Bulletin 2008/06**

(73) Titulaire: **STMicroelectronics N.V.
Amsterdam (NL)**

(72) Inventeur: **Van Zanten, François
38240, Meylan (FR)**

(74) Mandataire: **de Beaumont, Michel
Cabinet Beaumont
1, rue Champollion
38000 Grenoble (FR)**

(56) Documents cités:
**FR-A1- 2 854 008        US-A- 5 917 376**

• **MATSUURA T ET AL: "A 1.2-V FEEDFORWARD AMPLIFIER AND A/D CONVERTER FOR MIXED ANALOG/ DIGITAL LSLS" IEICE TRANSACTIONS ON ELECTRONICS, ELECTRONICS SOCIETY, TOKYO, JP, vol. E79-C, no. 12, décembre 1996 (1996-12), pages 1666-1677, XP000692116 ISSN: 0916-8524**
• **BHARATH KUMAR THANDRI ET AL: "A Robust Feedforward Compensation Scheme for Multistage Operational Transconductance Amplifiers With No Miller Capacitors" IEEE JOURNAL OF SOLID-STATE CIRCUITS, IEEE SERVICE CENTER, PISCATAWAY, NJ, US, vol. 38, no. 2, février 2003 (2003-02), XP011065959 ISSN: 0018-9200**

**Description**

Domaine de l'invention

La présente invention concerne le domaine des amplificateurs, et plus particulièrement des amplificateurs comprenant au moins deux étages de gain.

Exposé de l'art antérieur

Un amplificateur comprenant au moins deux étages de gain est généralement constitué d'un amplificateur à transconductance d'entrée suivi d'un ou de plusieurs amplificateurs à transconductance. Un amplificateur comprenant au moins deux étages de gain présente l'avantage, par rapport à un amplificateur à un étage unique, de pouvoir fonctionner sous faible tension tout en permettant une dynamique de sortie pouvant presque atteindre la tension d'alimentation. Un second avantage est la possibilité d'obtenir un gain en boucle ouverte élevé.

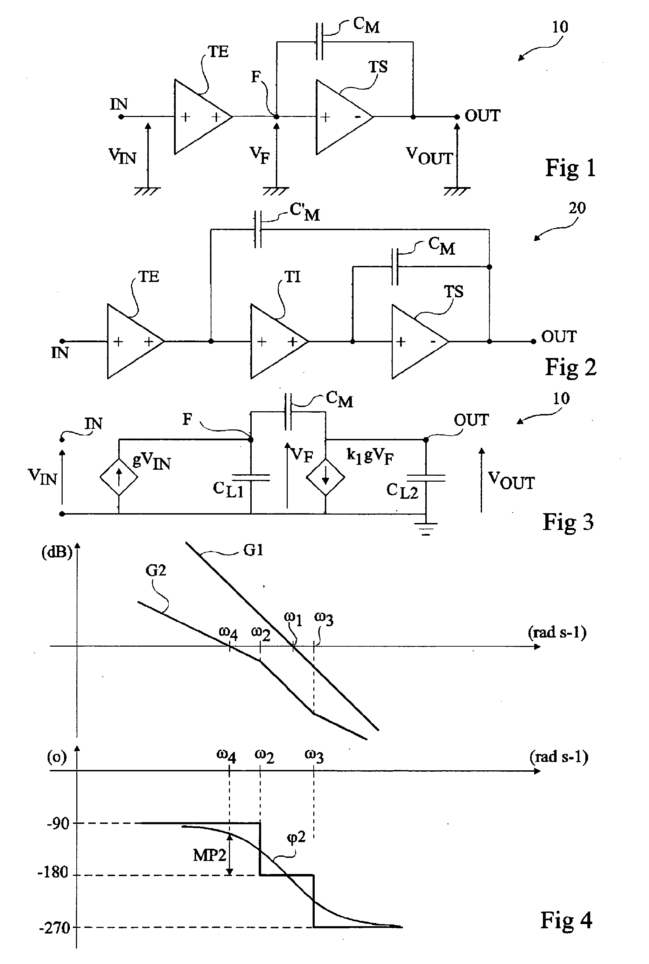

La figure 1 représente schématiquement un exemple d'amplificateur 10 à deux étages de gain comprenant une borne d'entrée IN et une borne de sortie OUT. L'amplificateur 10 comporte un amplificateur à transconductance TE ayant une entrée "+" reliée à la borne d'entrée IN et une borne de sortie "+" reliée à un noeud F. Une borne d'entrée "+" d'un amplificateur inverseur à transconductance TS est reliée au noeud F. La sortie "-" de l'amplificateur TS est reliée à la borne de sortie OUT. On appelle $V_{IN}$, $V_F$ et $V_{OUT}$ les tensions respectivement à la borne IN, au noeud F et à la borne OUT. Pour assurer la stabilité en boucle fermée, il est nécessaire de compenser l'amplificateur TS. Ceci est généralement réalisé par une compensation dite compensation Miller en prévoyant un condensateur $C_M$ entre l'entrée "+" et la sortie "-" de l'amplificateur TS. Le condensateur $C_M$ est généralement appelé condensateur Miller.

La figure 2 représente un exemple classique d'un amplificateur 20 à trois étages de gain. Par rapport à l'amplificateur 10 de la figure 1, l'amplificateur 20 comprend un amplificateur à transconductance TI intermédiaire disposé entre les amplificateurs TE et TS. Plus précisément, la sortie "+" de l'amplificateur TE est reliée à l'entrée "+" de l'amplificateur TI et la sortie "+" de l'amplificateur TI est reliée à l'entrée "+" de l'amplificateur TS. Pour assurer la stabilité en boucle fermée de l'amplificateur 20, on prévoit, en plus du condensateur Miller $C_M$ précédemment décrit, un condensateur Miller $C_M'$ supplémentaire entre l'entrée "+" de l'amplificateur TI et la sortie "-" de l'amplificateur TS. Une telle disposition des condensateurs $C_M$ et $C_M'$ est généralement appelée structure à condensateurs Miller emboîtés (en anglais Nested Miller).

Le principe de la compensation Miller peut être mis en évidence en déterminant, de façon simplifiée, la fonction de transfert de l'amplificateur 10 représenté en figure 1.

La figure 3 représente un schéma électrique équivalent de l'amplificateur 10 de la figure 1. On cherche à déterminer l'évolution de la phase de la fonction de transfert de l'amplificateur 10 au niveau de la fréquence de gain unitaire, ou fréquence de coupure, de l'amplificateur 10. Une telle fréquence de coupure peut, de façon classique, être de l'ordre de 1 GHz. Pour ce faire, une approximation suffisante de la fonction de transfert de l'amplificateur 10 est obtenue en considérant que l'amplificateur à transconductance TE est équivalent à un amplificateur à transconductance idéal de gain tension-courant g chargé au noeud F par un condensateur de capacité $C_{L1}$ et que l'amplificateur TS est équivalent à un amplificateur à transconductance idéal de gain tension-courant $k_1g$ chargé à la borne OUT par un condensateur $C_{L2}$.

Dans le plan de Laplace, la loi des noeuds au noeud F s'écrit de la façon suivante :

$$-gV_{INT} + (pC_{L1} + pC_M)V_F - pC_M V_{OUT} = 0 \qquad (1)$$

et la loi des noeuds à la borne OUT s'écrit :

$$(k_1g - pC_M)V_F + (pC_{L2} + pC_M)V_{OUT} = 0 \qquad (2)$$

A partir des relations (1) et (2), on obtient la fonction de transfert suivante :

$$-\frac{V_{OUT}}{V_{IN}} = \frac{1}{p\dfrac{C_M}{g}} \cdot \frac{1 - p\dfrac{C_M}{k_1 g}}{1 + p\dfrac{C_{L1}C_{L2} + C_{L1}C_M + C_{L2}C_M}{g k_1 C_M}} \qquad (3)$$

En l'absence de compensation Miller, c'est-à-dire pour $C_M$ nul, la relation (3) devient :

$$-\frac{V_{OUT}}{V_{IN}} = \frac{1}{p^2 \dfrac{C_{L1}C_{L2}}{k_1 g^2}} \qquad (4)$$

La figure 4 est un graphe de Bode représentant, en partie, l'évolution asymptotique des gains G1 et G2 de la fonction de transfert de l'amplificateur 10 respectivement sans et avec compensation Miller et un graphe de Bode représentant l'évolution de la phase φ2 de la fonction de transfert de l'amplificateur 10 avec compensation Miller.

La fonction de transfert simplifiée de l'amplificateur 10 en l'absence de compensation Miller comprend un pôle du second ordre à l'origine. La pulsation $\omega_1$ correspondant à la fréquence de coupure de l'amplificateur 10 sans compensation est donnée par la relation suivante :

$$\omega_1 = \frac{\sqrt{k_1} \cdot g}{\sqrt{C_{L1}C_{L2}}} \qquad (5)$$

La phase, non représentée, de l'amplificateur 10 sans compensation Miller, est proche de -180° à la fréquence de coupure (pulsation $\omega_1$) de sorte que la marge de phase est proche de 0°.

La fonction de transfert simplifiée de l'amplificateur 10 avec compensation Miller comprend :

-  un premier pôle, appelé pôle dominant, à l'origine ;
-  un second pôle, appelé pôle non dominant, à la pulsation $\omega_2$ donnée par la relation suivante :

$$\omega_2 = \frac{g k_1 C_M}{C_{L1}C_{L2} + C_{L1}C_M + C_{L2}C_M} \qquad (6)$$

la capacité $C_M$ étant choisie pour rejeter le pôle (pulsation $\omega_2$) au-delà de la fréquence de coupure (pulsation $\omega_4$) de l'amplificateur 10 avec compensation Miller ; et
-  un zéro à la pulsation $\omega_3$ donnée par la relation suivante :

$$\omega_3 = \frac{k_1 g}{C_M} \qquad (7)$$

Le zéro étant situé sur le demi-axe droit du plan de Laplace, il introduit une chute de phase en même temps qu'un accroissement du gain. Il s'agit d'un inconvénient classique de la compensation Miller et des modifications du circuit de la figure 1 sont généralement mises en oeuvre pour rejeter le zéro bien au-delà de la fréquence de coupure de l'amplificateur.

Le pôle dominant détermine la fréquence de coupure, correspondant à la pulsation $\omega_4$, de l'amplificateur 10 avec compensation Miller permettant d'obtenir une marge de phase MP2 convenable, par exemple supérieure à 60°. La pulsation $\omega_4$ est donnée par la relation approchée suivante :

$$\omega_4 \approx \frac{g}{C_M} \qquad\qquad\qquad (8)$$

Pour obtenir une marge de phase MP2 suffisante, on peut montrer qu'il faut que la fréquence de coupure (pulsation $\omega_4$) de l'amplificateur 10 avec compensation Miller soit inférieure à la fréquence de coupure (pulsation $\omega_1$) de l'amplificateur 10 sans compensation Miller.

Un inconvénient de la compensation Miller est donc qu'on obtient une forte réduction de la fréquence de coupure (pulsation $\omega_4$) de l'amplificateur. En outre, on observe l'apparition de non linéarité due à la vitesse de balayage (en anglais Slew Rate) importante de l'amplificateur qui résulte de la présence des condensateurs Miller.

La publication 'Matsuura T ET AL "A 1.2-V Feedforward Amplifier and A/D Converter for Mixed Analog/Digital LSIs", IEICE Trannsactions on Electronics, Electronics Society, Tokyo, JP, vol. E79-C,no. 12, décembre 1996, pages 1666-1677' montre une compensation en fréquence utilisant une capacité de compensation en aval (feedforward capacitor).

Résumé de l'invention

La présente invention vise un amplificateur comprenant au moins deux étages de gain dont la stabilité en boucle fermée est assurée sans utilisation de condensateurs Miller.

Selon un autre objet de la présente invention, la structure de l'amplificateur selon l'invention est peu modifiée par rapport à un amplificateur classique à au moins deux étages.

Pour atteindre tout ou partie de ces objets ainsi que d'autres, un aspect de la présente invention prévoit un circuit amplificateur comprenant une succession d'étages d'amplification dont au moins un premier étage d'amplification recevant un premier signal et un deuxième étage d'amplification en aval du premier étage d'amplification ; un étage à gain unitaire adapté à recevoir le premier signal et à fournir un second signal correspondant à la copie à basse impédance du premier signal ; et un troisième étage d'amplification dont l'entrée est reliée à la sortie de l'étage à gain unitaire par un condensateur et dont la sortie est reliée à la sortie du deuxième étage d'amplification.

Selon un exemple de réalisation de la présente invention, le circuit amplificateur comprend, en outre, un quatrième étage d'amplification entre les premier et deuxième étages d'amplification ; et un cinquième étage d'amplification dont l'entrée est reliée à la sortie de l'étage à gain unitaire par un condensateur supplémentaire et dont la sortie est reliée à la sortie du quatrième étage d'amplification.

Selon un exemple de réalisation de la présente invention, l'étage à gain unitaire comprend au moins un transistor MOS monté en source suiveuse.

Selon un exemple de réalisation de la présente invention, le circuit amplificateur comprend des première et seconde bornes d'entrée différentielles. Le premier étage d'amplification comprend des premier et deuxième transistors MOS d'un premier type de conductivité, la grille du premier transistor étant reliée à la première borne d'entrée et la grille du deuxième transistor étant reliée à la seconde borne d'entrée. Le deuxième étage d'amplification comprend des troisième et quatrième transistors MOS d'un second type de conductivité. L'étage à gain unitaire comprend des cinquième et sixième transistors MOS du premier type de conductivité, la grille du cinquième transistor étant reliée à la première borne d'entrée et la grille du sixième transistor étant reliée à la seconde borne d'entrée. Le troisième étage d'amplification comprend des septième et huitième transistors MOS du premier type de conductivité, l'une des bornes de puissance du septième transistor étant reliée à l'une des bornes de puissance du troisième transistor et l'une des bornes de puissance du huitième transistor étant reliée à l'une des bornes de puissance du quatrième transistor. La grille du troisième transistor est reliée à l'une des bornes de puissance du deuxième transistor, la grille du quatrième transistor étant reliée à l'une des bornes de puissance du premier transistor, la grille du septième transistor étant reliée à l'une des bornes de puissance du cinquième transistor par l'intermédiaire d'un premier condensateur et la grille du huitième transistor étant reliée à l'une des bornes de puissance du sixième transistor par l'intermédiaire d'un deuxième condensateur ou la grille du troisième transistor est reliée à l'une des bornes de puissance du premier transistor, la grille du quatrième transistor étant reliée à l'une des bornes de puissance du deuxième transistor, la grille du septième transistor étant reliée à l'une des bornes de puissance du cinquième transistor par l'intermédiaire d'un premier condensateur et la grille du huitième transistor étant reliée à l'une des bornes de puissance du sixième transistor par l'intermédiaire d'un deuxième condensateur ou la grille du troisième transistor est reliée à l'une des bornes de puissance du premier transistor, la grille du quatrième transistor étant reliée à l'une des bornes de puissance du deuxième transistor, la grille du septième transistor étant reliée à l'une des bornes de puissance du sixième transistor par l'intermédiaire d'un premier condensateur et la grille du huitième transistor étant reliée à l'une des bornes de puissance du cinquième transistor par l'intermédiaire d'un deuxième condensateur.

Selon un exemple de réalisation de la présente invention, la grille du septième transistor est reliée à une borne d'une source de courant par l'intermédiaire d'une première résistance et la grille du huitième transistor est reliée à la borne de la source de courant par l'intermédiaire d'une deuxième résistance.

Selon un exemple de réalisation de la présente invention, le circuit amplificateur comprend, en outre, des neuvième et dixième transistors MOS du premier type de conductivité, l'une des bornes de puissance du neuvième transistor étant reliée à l'une des bornes de puissance du cinquième transistor et l'une des bornes de puissance du dixième transistor étant reliée à l'une des bornes de puissance du sixième transistor, la grille du neuvième transistor étant reliée à l'une des bornes de puissance du sixième transistor par l'intermédiaire d'un troisième condensateur et la grille du dixième transistor étant reliée à l'une des bornes de puissance du cinquième transistor par l'intermédiaire d'un quatrième condensateur.

Selon un exemple de réalisation de la présente invention, la grille du neuvième transistor est reliée à une borne d'une source de courant par l'intermédiaire d'une troisième résistance et la grille du dixième transistor est reliée à la borne de la source de courant par l'intermédiaire d'une quatrième résistance.

Selon un exemple de réalisation de la présente invention, le premier étage d'amplification comprend des onzième et douzième transistors MOS du premier type de conductivité, l'une des bornes de puissance du onzième transistor étant reliée à l'une des bornes de puissance du premier transistor et l'une des bornes de puissance du douzième transistor étant reliée à l'une des bornes de puissance du deuxième transistor, le circuit amplificateur comprenant un circuit de polarisation des grilles des onzième et douzième transistors.

Selon un exemple de réalisation de la présente invention, le circuit de polarisation comprend des treizième et quatorzième transistors MOS du premier type de conductivité, montés en diode, la grille du treizième transistor étant reliée à la grille du onzième transistor et la grille du quatorzième transistor étant reliée à la grille du douzième transistor, l'une des bornes de puissance du treizième transistor étant reliée à l'une des bornes de puissance du cinquième transistor et l'une des bornes de puissance du quatorzième transistor étant reliée à l'une des bornes de puissance du sixième transistor, les bornes de puissance du treizième transistor étant reliées entre elles par un cinquième condensateur et les bornes de puissance du quatorzième transistor étant reliées entre elles par un sixième condensateur.

Selon un exemple de réalisation de la présente invention, le circuit amplificateur comprend un quatrième étage d'amplification entre le premier et le deuxième étages d'amplification, le quatrième étage d'amplification comprenant des quinzième et seizième transistors MOS du second type de conductivité, la grille du quinzième transistor MOS étant reliée à l'une des bornes de puissance du premier transistor et la grille du seizième transistor MOS étant reliée à l'une des bornes de puissance du deuxième transistor, la grille du troisième transistor étant reliée à l'une des bornes de puissance du quinzième transistor et la grille du quatrième transistor étant reliée à l'une des bornes de puissance du seizième transistor.

Un aspect de la présente invention prévoit un circuit intégré comprenant au moins un circuit amplificateur tel que précédemment défini.

Un aspect de la présente invention prévoit un convertisseur analogique-numérique, notamment du type pipeline, comprenant au moins un circuit amplificateur tel que précédemment défini.

Un aspect de la présente invention prévoit un procédé d'amplification d'un premier signal comprenant l'amplification du premier signal par un premier chemin d'amplification dans lequel le premier signal est amplifié successivement plusieurs fois, comprenant au moins une première amplification du premier signal et une deuxième amplification ultérieure fournissant un deuxième signal ; et l'amplification du premier signal par un second chemin d'amplification consistant à fournir un troisième signal correspondant à la recopie à basse impédance du premier signal, et à imposer, aux fréquences supérieures à une fréquence donnée, la phase du deuxième signal à partir du troisième signal.

Brève description des dessins

Ces objets, caractéristiques et avantages, ainsi que d'autres de la présente invention seront exposés en détail dans la description suivante d'exemples de réalisation particuliers faite à titre non-limitatif en relation avec les figures jointes parmi lesquelles :

les figures 1 et 2, précédemment décrites, représentent des exemples classiques d'amplificateur respectivement à deux et trois étages de gain ;
la figure 3, précédemment décrite, représente un schéma électrique équivalent de l'amplificateur de la figure 1 ;
la figure 4, précédemment décrite, représente l'évolution du gain et de la phase de la fonction de transfert de l'amplificateur de la figure 1 en présence et en absence de compensation Miller ;
la figure 5 représente un exemple de réalisation d'un amplificateur à deux étages de gain selon l'invention ;
la figure 6 représente un schéma électrique équivalent de l'amplificateur de la figure 5 ;
la figure 7 représente, de façon schématique, l'évolution du gain et de la phase de la fonction de transfert de l'amplificateur de la figure 5 ;
la figure 8 représente un exemple de réalisation d'un amplificateur à trois étages de gain selon l'invention ;

la figure 9 représente un exemple de réalisation plus détaillé d'un amplificateur à entrées et sorties différentielles selon l'invention qui se base sur la structure de l'amplificateur de la figure 5 ;
la figure 10 représente une variante de l'amplificateur de la figure 9 ; et
la figure 11 représente un exemple de réalisation plus détaillé d'un amplificateur à entrées et sorties différentielles selon l'invention qui se base sur la structure de l'amplificateur de la figure 8.

Description détaillée

Par souci de clarté, de mêmes éléments ont été désignés par de mêmes références aux différentes figures.

La présente invention prévoit, pour un amplificateur ayant au moins deux étages d'amplification, de recopier à basse impédance le signal d'entrée de l'amplificateur et d'utiliser ce signal à basse impédance pour forcer, aux fréquences supérieures, la phase de certains noeuds intermédiaires bien choisis de l'amplificateur et ainsi de permettre le maintien de la marge de phase nécessaire à la bonne stabilité en boucle fermée.

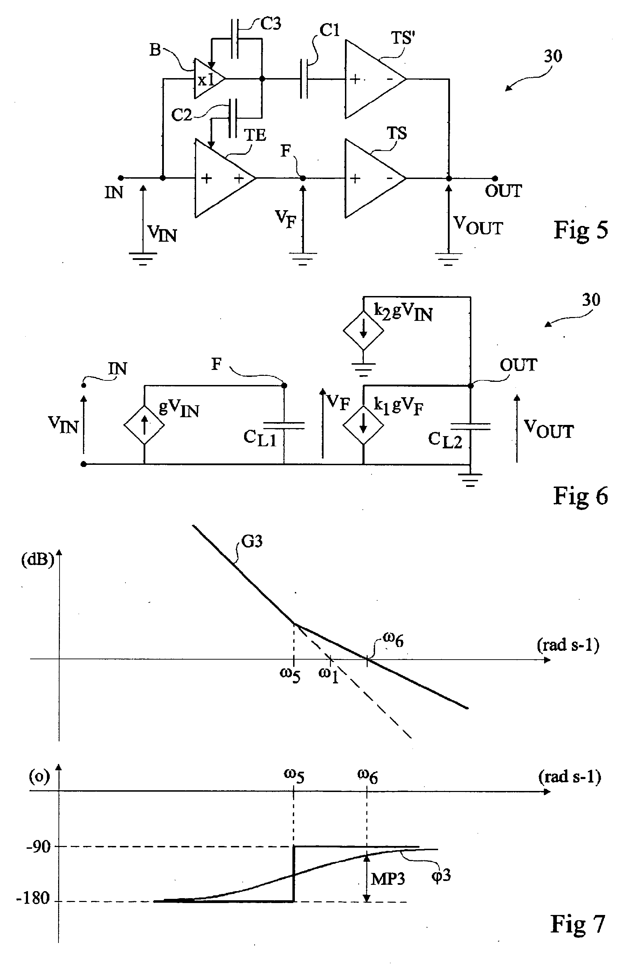

La figure 5 représente un exemple de réalisation d'un amplificateur 30 à deux étages de gain selon l'invention qui comprend les éléments de l'amplificateur 10 représenté en figure 1 à la différence que le condensateur de compensation Miller $C_M$ est absent. En outre, l'amplificateur 30 comprend un amplificateur B à gain unitaire dont l'entrée est reliée à la borne IN et dont la sortie est reliée à l'entrée "+" d'un amplificateur à transconductance TS' par l'intermédiaire d'un condensateur C1. La sortie "-" de l'amplificateur TS' est reliée à la sortie "-" de l'amplificateur TS. Comme cela sera décrit plus en détail par la suite, il peut être avantageux, en outre, de redistribuer la sortie de l'amplificateur B sur lui-même par l'intermédiaire d'un condensateur C3 et sur l'amplificateur TE par l'intermédiaire d'un condensateur C2.

Le principe de fonctionnement de l'amplificateur 30 est le suivant. L'amplificateur B à gain unitaire recopie sous basse impédance le signal d'entrée $V_{IN}$ et le redistribue en haute fréquence par l'intermédiaire du condensateur C1 sur l'entrée de l'amplificateur TS', la sortie de l'amplificateur TS' étant reliée à la borne de sortie OUT. L'amplificateur TS assure le chemin habituel du signal reçu par l'amplificateur 30 de l'entrée vers la sortie de l'amplificateur 30 tandis que, l'amplificateur TS', dont la sortie est disposée en parallèle de la sortie de l'amplificateur TS, assure un chemin direct en haute fréquence du signal reçu par l'amplificateur 30. En outre, comme cela sera décrit plus en détail par la suite, le fait de redistribuer la sortie de l'amplificateur B à gain unitaire sur lui-même et sur l'amplificateur TE permet d'augmenter la vitesse de fonctionnement et la réponse à haute fréquence des amplificateurs B et TE.

La figure 6 représente un schéma électrique équivalent de l'amplificateur 30 de la figure 5, les condensateurs C2 et C3 n'étant pas présents. Le schéma électrique de la figure 6 est identique au schéma représenté en figure 3 à la différence que le condensateur Miller $C_M$ est absent. En outre, on considère que l'amplificateur TS' est équivalent à un amplificateur à transconductance idéal de gain tension-courant $k_2g$ chargé par le condensateur $C_{L2}$. Comme l'amplificateur TS' est supposé idéal, c'est-à-dire avec une impédance d'entrée infinie, on peut ne pas représenter l'amplificateur B. En outre, on se place à des fréquences pour lesquelles le condensateur $C_1$ peut être considéré comme équivalent à un circuit fermé.

Dans le plan de Laplace, la loi des noeuds au noeud F s'écrit de la façon suivante :

$$-gV_{IN} + pC_{L1}V_F = 0 \qquad\qquad (9)$$

et la loi des noeuds à la borne OUT s'écrit de la façon suivante :

$$k_1gV_F + pC_{L2}V_{OUT} + k_2gV_{IN} = 0 \qquad\qquad (10)$$

A partir des relations (9) et (10), on obtient la fonction de transfert simplifiée suivante :

$$-\frac{V_{OUT}}{V_{IN}} = \frac{1}{p^2} \cdot \frac{k_1g^2}{C_{L1}C_{L2}} \cdot (1 + p\frac{k_2C_{L1}}{k_1g}) \qquad\qquad (11)$$

La fonction de transfert simplifiée de l'amplificateur 30 comporte donc un pôle du second ordre à l'origine comme pour l'amplificateur 10 sans compensation. En outre, la fonction de transfert de l'amplificateur 30 comprend un zéro, introduit par l'amplificateur TS', à la pulsation $\omega_5$ donnée par la relation suivante :

$$\omega_5 = \frac{k_1 g}{k_2 C_{L1}} \qquad\qquad (12)$$

Le zéro étant situé sur le demi-axe gauche du plan de Laplace, il produit une contribution de phase positive et une augmentation du gain.

La figure 7 est un graphe de Bode représentant, en partie, l'évolution asymptotique du gain G3 et l'évolution de la phase φ3 de la fonction de transfert simplifiée de l'amplificateur 30. Par le choix des caractéristiques des amplificateurs TE, TS et TS', on peut s'assurer que la pulsation $\omega_5$ est inférieure à la pulsation $\omega_1$ correspondant à la fréquence de coupure de l'amplificateur sans compensation. Le zéro permet alors de remonter la phase de la fonction de transfert avant la pulsation $\omega_1$. On obtient ainsi une marge de phase MP3 à la fréquence de coupure de l'amplificateur 30 (correspondant à la pulsation $\omega_6$) suffisante pour assurer la stabilité de l'amplificateur 30 en boucle fermée. De plus, la présente invention permet de ne pas réduire la vitesse de l'amplificateur puisque la fréquence de coupure de l'amplificateur 30 (pulsation $\omega_6$) est supérieure à la fréquence de coupure de l'amplificateur 10 sans compensation (pulsation $\omega_1$).

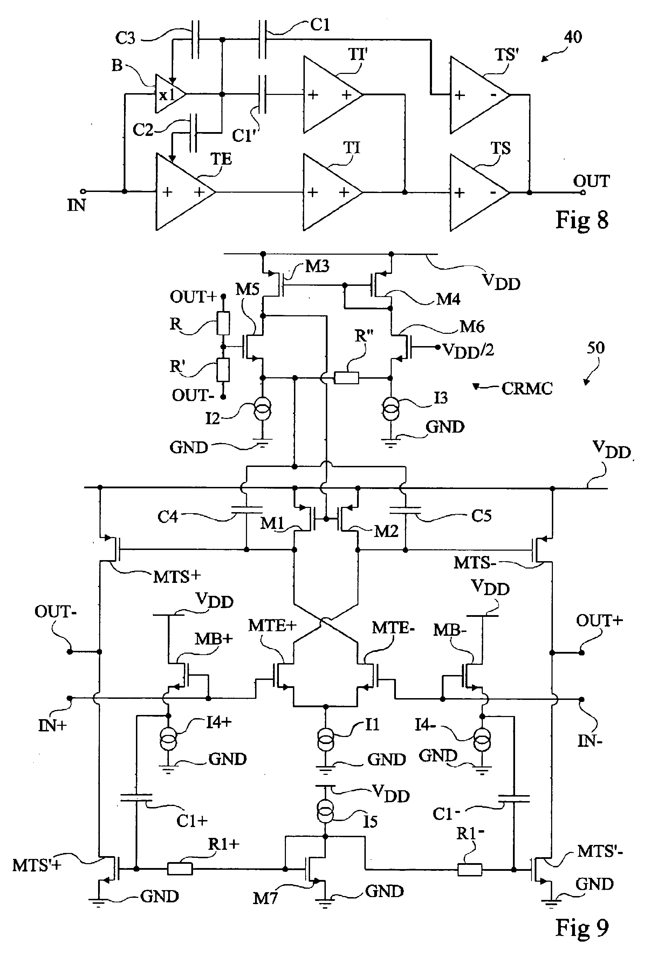

La figure 8 représente un exemple de réalisation d'un amplificateur 40 à trois étages de gain selon l'invention qui comprend les éléments de l'amplificateur 20 représenté en figure 2 à la différence que les condensateurs Miller $C_M$, $C_M$' sont absents. L'amplificateur 40 comprend les mêmes éléments de compensation que pour l'amplificateur 30 représenté en figure 3, à savoir l'amplificateur B à gain unitaire dont l'entrée est reliée à la borne IN et dont la sortie est reliée à l'entrée de l'amplificateur TS' par l'intermédiaire du condensateur C1, la sortie de l'amplificateur TS' étant reliée à la borne de sortie OUT. L'amplificateur 40 comprend, en outre, un amplificateur à transconductance TI' dont l'entrée "+" est reliée à la sortie de l'amplificateur à gain unitaire B par l'intermédiaire d'un condensateur C1' et dont la sortie "+" est reliée à la sortie "+" de l'amplificateur TI.

La figure 9 représente un exemple de réalisation d'un amplificateur 50 à deux entrées différentielles IN+ et IN- et à deux sorties différentielles OUT+ et OUT- qui se base sur la structure de l'amplificateur 30 représenté en figure 5, dans sa version simplifiée sans les condensateurs C2 et C3. Par rapport à l'amplificateur 30, l'amplificateur 50 comprend deux lignes d'amplification de sorte que pour l'amplificateur 50, tous les amplificateurs TE, TS et TS' sont à deux entrées et deux sorties. En outre, les éléments B et C1 sont dédoublés pour l'amplificateur 50 et on associe le suffixe "+" aux composants associés au chemin reliant l'entrée IN+ à la sortie OUT- et le suffixe "-" au composants associés au chemin reliant l'entrée IN- à la sortie OUT+. Sauf indication contraire, des composants désignés par une même référence respectivement suivie du suffixe "+" et "-" sont identiques.

L'amplificateur TE est constitué d'un transistor MOS à canal N MTE+ dont la grille est reliée à la borne d'entrée IN+ et d'un transistor MOS à canal N MTE- dont la grille est reliée à la borne d'entrée IN-. Les sources des transistors MTE+ et MTE- sont reliées à une borne d'une source de courant constant I1 dont l'autre borne est reliée à une source d'un potentiel de référence bas, par exemple la masse GND.

L'amplificateur TS comprend un transistor MOS à canal P MTS+ dont la grille est reliée au drain du transistor MTE- et un transistor MOS à canal P MTS- dont la grille est reliée au drain du transistor MTE+. Les sources des transistors MTS+ et MTS- sont reliées à une source d'un potentiel de référence haut, par exemple l'alimentation $V_{DD}$ du circuit. Le drain du transistor MTS+ est relié à la borne de sortie OUT- et le drain du transistor MTS- est relié à la borne de sortie OUT+.

L'amplificateur 50 comprend, de façon classique, un circuit de contre réaction en mode commun CRMC qui peut avoir n'importe quelle structure connue. A titre d'exemple, on a représenté un circuit de contre réaction en mode commun CRMC ayant la structure décrite dans le brevet français 2 854 008 déposé au nom de la demanderesse. Le circuit CRMC comprend des transistors MOS à canal P M1 et M2 dont les grilles sont reliées en commun et dont les sources sont reliées à $V_{DD}$. Le drain du transistor M1 est relié à la grille du transistor MTS+ et le drain du transistor M2 est relié à la grille du transistor MTS-. Le circuit CRMC comprend un miroir de courant constitué de deux transistors MOS à canal P M3 et M4 dont les grilles sont reliées en commun et dont les sources sont reliées à $V_{DD}$. Le drain du transistor M3 est relié aux grilles des transistors M1 et M2 et au drain d'un transistor MOS à canal N M5. La source du transistor M5 est reliée à une borne d'une source de courant constant I2 dont l'autre borne est reliée à la masse GND. La grille et le drain du transistor M4 sont reliés au drain d'un transistor MOS à canal N M6. La source du transistor M6 est reliée à une borne d'une source de courant constant I3 dont l'autre borne est reliée à la masse GND. La grille du transistor M5 est reliée à la borne OUT+ par l'intermédiaire d'une résistance R et à la borne OUT- par l'intermédiaire d'une résistance R'. La grille du transistor M6 reçoit une tension égale à la moitié de la tension $V_{DD}$. La source du transistor M5 est reliée à la source du transistor M6 par l'intermédiaire d'une résistance R", à la grille du transistor MTS+ par l'intermédiaire d'un condensateur C4 et à la grille du transistor MTS-par l'intermédiaire d'un condensateur C5.

L'amplificateur B+ est constitué d'un transistor MOS à canal N MB+ monté en source suiveuse. Le drain du transistor MB+ est relié à l'alimentation $V_{DD}$. La source du transistor MB+ est reliée à une borne d'une source de courant constant I4+ dont l'autre borne est reliée à la masse GND. La grille du transistor MB+ est reliée à la borne d'entrée IN+. De façon analogue, l'amplificateur B- est constitué d'un transistor MOS à canal N MB- monté en source suiveuse. Le drain du transistor MB- est relié à l'alimentation $V_{DD}$. La source du transistor MB- est reliée à une borne d'une source de courant constant I4- dont l'autre borne est reliée à la masse GND. La grille du transistor MB- est reliée à la borne d'entrée IN-.

L'amplificateur TS' est constitué d'un transistor MOS à canal N MTS'+ dont le drain est relié à la borne de sortie OUT- et dont la source est reliée à la masse GND et d'un transistor MOS à canal N MTS'- dont le drain est relié à la borne de sortie OUT+ et dont la source est reliée à la masse GND. La grille du transistor MTS'+ est reliée à la grille d'un transistor MOS à canal N M7 par l'intermédiaire d'une résistance R1+. La grille du transistor MTS'- est reliée à la grille du transistor M7 par l'intermédiaire d'une résistance R1-. Le drain et la grille du transistor M7 sont reliés à une borne d'une source de courant 15 dont l'autre borne est reliée à VDD. La source du transistor M7 est reliée à la masse GND. La grille du transistor MTS'+ est reliée à la source du transistor MB+ par l'intermédiaire du condensateur C1+ et la grille du transistor MTS'- est reliée à la source du transistor MB- par l'intermédiaire du condensateur C1-.

Le fonctionnement de l'amplificateur 50 va maintenant être décrit. Les transistors MB+ et MB- étant montés en source suiveuse, ils reproduisent à faible impédance à leur source le signal à la borne d'entrée IN+ et IN- correspondante. Aux basses fréquences, les condensateurs C1+ et C1- sont sensiblement équivalents à des circuits ouverts. Les transistors MTS'- et MTS'+ de l'amplificateur TS' jouent le rôle de sources de courant de polarisation des transistors MTS- et MTS+ de l'amplificateur TS, la polarisation continue des grilles des transistors MTS'+ et MTS'- étant réalisée par l'intermédiaire des résistances R1- et R1+. L'amplificateur 50 fonctionne alors comme un amplificateur à deux étages de gain classique. Aux fréquences élevées, les condensateurs C1+ et C1- sont sensiblement équivalents à des circuits fermés de sorte que les tensions aux sources des transistors MB+ et MB- sont respectivement appliquées aux grilles des transistors MTS'+ et MTS'-. Ceci permet de forcer la phase des signaux aux bornes de sortie OUT+ et OUT-. De façon schématique, on peut considérer, aux fréquences élevées, que les transistors MTS+ et MTS- jouent le rôle de sources de courant constant de polarisation des transistors MTS'+ et MTS'-. En effet, les signaux appliqués aux grilles des transistors MTS+ et MTS- suivent le chemin d'amplification habituel et sont donc très atténués aux hautes fréquences. La constante de temps R1+C1+ (respectivement R1-C1-) détermine la fréquence à partir de laquelle le rattrapage de phase est actif.

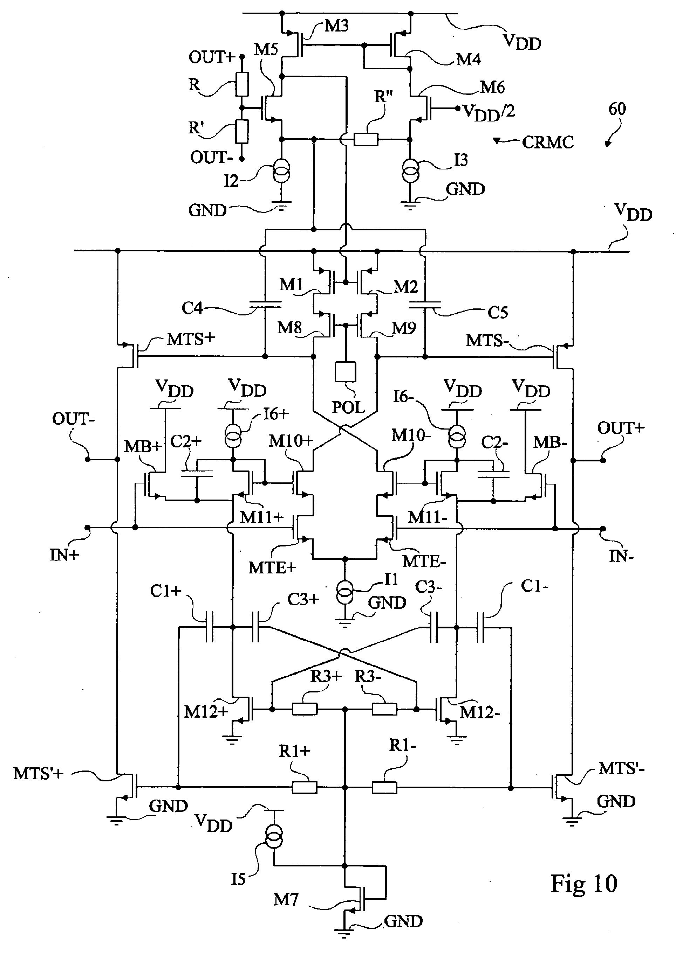

La figure 10 représente un amplificateur 60 qui correspond à une variante de l'amplificateur 50.

Par rapport à l'amplificateur 50, on prévoit un montage de type cascode des transistors M1 et M2. Pour ce faire, l'amplificateur 60 comprend des transistors MOS à canal P M8 et M9 dont les grilles sont reliées à une source d'une tension de polarisation POL. Le drain du transistor M8 est relié à la grille du transistor MTS+ et la source du transistor M8 est reliée au drain du transistor M1. Le drain du transistor M9 est relié à la grille du transistor MTS- et la source du transistor M9 est reliée au drain du transistor M2.

De façon analogue, on prévoit un montage de type cascode des transistors MTE+ et MTE-. Pour ce faire, on prévoit un transistor MOS à canal N M10+ dont la source est reliée au drain du transistor MTE+ et dont le drain est relié au drain du transistor M9. Par ailleurs, on prévoit un transistor MOS à canal N M10- dont la source est reliée au drain du transistor MTE- et dont le drain est relié au drain du transistor M8.

L'alimentation des grilles des transistors M10+ et M10- est réalisée par un circuit de neutrodynage. Pour ce faire, la grille du transistor M10+ est reliée à la grille d'un transistor MOS à canal N M11+, monté en diode. Le drain et la grille du transistor M11+ sont reliés à une borne d'une source de courant constant I6+ dont l'autre borne est reliée à $V_{DD}$. La source du transistor M11+ est reliée à la source du transistor MB+. Le drain du transistor M11+ est relié à la source du transistor MB+ par l'intermédiaire du condensateur C2+. La source du transistor M11+ est reliée au drain d'un transistor MOS à canal N M12+ dont la source est reliée à la masse GND. La grille du transistor M12+ est reliée au drain du transistor M7 par l'intermédiaire d'une résistance R3+. De façon analogue, la grille du transistor M10- est reliée à la grille d'un transistor MOS à canal N M11-, monté en diode. La grille et le drain du transistor M11- sont reliés à une borne d'une source de courant constant I6- dont l'autre borne est reliée à $V_{DD}$. La source du transistor M11- est reliée à la source du transistor MB-. Le drain du transistor M11- est relié à la source du transistor MB- par l'intermédiaire du condensateur C2-. La source du transistor M11- est reliée au drain d'un transistor MOS à canal N M12- dont la source est reliée à la masse GND. La grille du transistor M12- est reliée au drain du transistor M7 par l'intermédiaire d'une résistance R3-. Les transistors M12+ et M12- constituent respectivement les sources de courant de polarisation des transistors MB+ et MB-. La polarisation continue des transistors M12+ et M12- est assurée respectivement par les résistances R3+ et R3-.

Par ailleurs, pour améliorer les performances des amplificateurs B+ et B-, le condensateur C3+ relie la source du transistor MB+ à la grille du transistor M12- et le condensateur C3- relie la source du transistor MB- à la grille du transistor M12+.

La recopie du signal à la borne d'entrée IN+ (respectivement IN-) à basse impédance permet de polariser le transistor M10+ (respectivement M10-). Le transistor M11+ (respectivement M11-), monté en diode, permet de remonter la tension appliquée à la grille du transistor M10+ (respectivement M10-) d'une tension grille-source. Le circuit de neutrodynage qui assure l'alimentation des grilles des transistors M10+ et M10- permet d'augmenter le gain et la bande passante de l'amplificateur TE et d'annuler sa capacité d'entrée. Les transistors M11+ et M11- sont respectivement court-circuités par les condensateurs C2+ et C2- afin de maintenir sur les grilles des transistors M10+ et M10- montés en cascode le signal d'entrée sous basse impédance en haute fréquence.

Le fait de relier les sources des transistors MB+ et MB- respectivement aux grilles des transistors M12- et M12+ par l'intermédiaire des condensateurs C3+ et C3- permet respectivement d'améliorer la vitesse des transistors MB+ et MB-. En effet, aux basses fréquences, les condensateurs C3+ et C3- sont équivalents à des circuits ouverts et les transistors M12+ et M12- sont commandés par une tension de grille constante. Aux hautes fréquences, les condensateurs C3+ et C3- sont équivalents à des circuits fermés et les signaux aux sources des transistors MB+ et MB- sont respectivement appliqués aux grilles des transistors M12- et M12+. La constante de temps R3+C3+ (respectivement R3-C3-) détermine la transition basses fréquences/hautes fréquences.

La recopie du signal d'entrée à basse impédance est donc utilisée pour commander les transistors M12+ et M12- aux hautes fréquences. Une telle disposition réactive (mais de gain proche de 1 si les géométries des transistors MB+ et M12- et MB- et M12+ sont égales, garantissant ainsi la stabilité) améliore considérablement la vitesse des transistors MB+ et MB- en transformant le circuit en Push-Pull pour les hautes fréquences. Ceci peut être illustré par un exemple. Lorsqu'on applique un front descendant à la borne d'entrée IN+, on souhaite que la tension à la source du transistor MB+ diminue le plus rapidement possible pour suivre la tension à la borne d'entrée IN+. L'application d'un front descendant à la borne d'entrée IN+ correspond à l'application d'un front montant sur la borne d'entrée IN-. Ceci entraîne, par l'intermédiaire du condensateur C3-, une augmentation de la tension à la grille du transistor M12+ monté en source commune. Il en résulte une diminution de la tension drain-source du transistor M12+ facilitant donc la diminution de la tension à la source du transistor MB+.

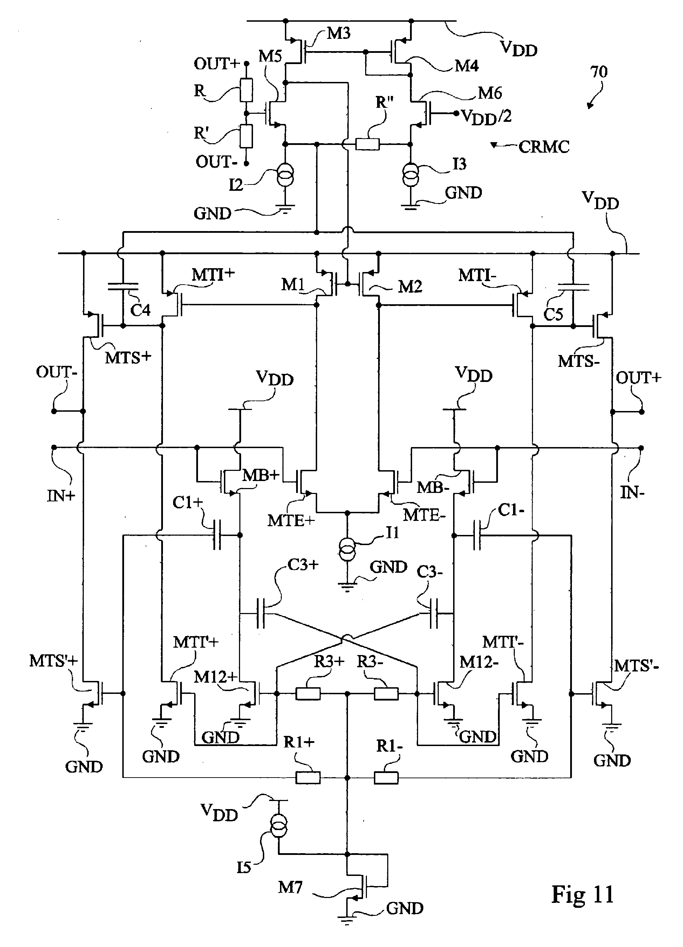

La figure 11 représente un amplificateur 70 à deux entrées différentielles IN+ et IN- et à deux sorties différentielles OUT+ et OUT- qui se base sur la structure de l'amplificateur 40 représenté en figure 8, le condensateur C2 n'étant pas présent. Les suffixes "+" et "-" sont utilisés de façon analogue à ce qui a été décrit précédemment pour l'amplificateur 50. Les amplificateurs TE, TS, TS' ont une structure identique à celle respectivement des amplificateurs TE, TS, TS' de l'amplificateur 50. Le circuit CRMC a une structure analogue à celle du circuit CRMC de l'amplificateur 50.

L'amplificateur TI est constitué de deux transistors MOS à canal P MTI+ et MTI-. La source du transistor MTI+ est reliée à l'alimentation $V_{DD}$, la grille du transistor MTI+ est reliée au drain du transistor MTE+ et le drain du transistor MTI+ est relié à la grille du transistor MTS+. La source du transistor MTI- est reliée à l'alimentation $V_{DD}$, la grille du transistor MTI- est reliée au drain du transistor MTE- et le drain du transistor MTI- est relié à la grille du transistor MTS-.

L'amplificateur TI' est constitué de deux transistors MOS à canal N MTI'+ et MTI'-. La source du transistor MTI'+ est reliée à la masse GND, le drain du transistor MTI'+ est relié au drain du transistor MTI+ et la grille du transistor MTI'+ est reliée à la grille du transistor M12+. La source du transistor MTI'- est reliée à la masse GND, le drain du transistor MTI'- est relié au drain du transistor MTI- et la grille du transistor MTI'- est reliée à la grille du transistor M12-.

Le fonctionnement de l'amplificateur 70 va maintenant être décrit. Les transistors MB+, MB- commandent aux hautes fréquences à la fois l'amplificateur TS', comme cela a été décrit précédemment en relation à l'amplificateur 50, mais également l'amplificateur TI', le rôle joué par les condensateurs C1'+ et C1'- étant rempli, dans le présent exemple de réalisation, par les condensateurs C3+ et C3-.

Les transistors MB+ et MB- étant montés en source suiveuse, ils reproduisent à faible impédance à leur source le signal à la borne d'entrée IN+ et IN- correspondante. Aux faibles fréquences, les condensateurs C3+ et C3- sont sensiblement équivalents à des circuits ouverts. Les transistors MTI'+ et MTI'- de l'amplificateur TI' jouent alors le rôle de sources de courant constant de polarisation respectivement des transistors MTI+ et MTI- de l'amplificateur TI, la polarisation continue des grilles des transistors MTI'+ et MTI'- étant respectivement réalisée par l'intermédiaire des résistances R3+ et R3-. L'amplificateur 70 fonctionne alors comme un amplificateur à trois étages de gain classique. Aux fréquences élevées, les condensateurs C3+ et C3- sont sensiblement équivalents à des circuits fermés de sorte que les tensions aux sources des transistors MB+ et MB- sont respectivement appliquées aux grilles des transistors MTI'- et MTI'+. Ceci permet de forcer la phase des signaux aux drains des transistors MTI'+ et MTI'-. La constante de temps R3+C3+ (respectivement R3-C3-) détermine la fréquence à partir de laquelle le rattrapage de phase est actif.

L'amplificateur 70 permet d'obtenir en outre de forts courants de sortie car les grilles des transistors MTS+ et MTS- peuvent descendre à un potentiel proche de la masse.

Bien entendu, l'amplificateur 70 peut comprendre un montage en cascode des transistors MTE+ et MTE- de façon analogue à ce qui a été décrit précédemment pour l'amplificateur 60 en relation à la figure 10. En outre, on peut prévoir un circuit de neutrodynage pour l'alimentation des grilles des transistors cascode comme pour l'amplificateur 60.

Les amplificateurs selon l'invention peuvent être utilisés dans tout circuit électronique dans lequel il est nécessaire d'effectuer une opération d'amplification rapide avec une grande linéarité. Il s'agit, par exemple, d'amplificateurs pour des convertisseurs analogique-numérique, notamment des convertisseurs du type pipeline, de filtres qui requièrent une grande linéarité, notamment des PMA (acronyme anglais pour Post Mixer Amplifier) utilisés en téléphonie mobile, etc...

La présente invention a été décrite en relation avec des amplificateurs comportant deux et trois étages d'amplification, mais elle s'adaptera sans difficulté à un amplificateur comportant plus de trois étages d'amplification.

La présente invention a été décrite en relation avec des transistors MOS d'un certain type de conductivité, mais elle s'adaptera sans difficulté à des transistors MOS du type de conductivité complémentaire, en réalisant une permutation des transistors MOS de type N par des transistors MOS de type P et réciproquement. En outre, la présente invention s'adaptera sans difficulté à des transistors bipolaires ou à une combinaison de transistors MOS et bipolaires.

**Revendications**

1.  Circuit amplificateur (30 ; 40 ; 50 ; 60 ; 70) comprenant :

    une succession d'étages d'amplification (TE, TI, TS) dont au moins un premier étage d'amplification (TE) recevant un premier signal ($V_{IN}$) et un deuxième étage d'amplification (TI, TS) en aval du premier étage d'amplification ;
    un étage (B) à gain unitaire adapté à recevoir le premier signal et à fournir un second signal correspondant à la copie à basse impédance du premier signal ; et
    un troisième étage d'amplification (TI', TS') dont l'entrée est reliée à la sortie de l'étage à gain unitaire par un condensateur (C1, C1') et dont la sortie est reliée à la sortie du deuxième étage d'amplification.

2.  Circuit amplificateur selon la revendication 1, comprenant en outre :

    un quatrième étage d'amplification (TI) entre les premier et deuxième étages d'amplification (TE, TS) ; et
    un cinquième étage d'amplification (TI') dont l'entrée est reliée à la sortie de l'étage à gain unitaire par un condensateur supplémentaire (C1') et dont la sortie est reliée à la sortie du quatrième étage d'amplification.

3.  Circuit amplificateur selon la revendication 1, dans lequel l'étage à gain unitaire (B) comprend au moins un transistor MOS monté en source suiveuse.

4.  Circuit amplificateur selon la revendication 1, comprenant des première et seconde bornes d'entrée différentielles (IN+, IN-),
    dans lequel le premier étage d'amplification (TE) comprend des premier et deuxième transistors MOS (MTE+, MTE-) d'un premier type de conductivité, la grille du premier transistor (MTE+) étant reliée à la première borne d'entrée (IN+) et la grille du deuxième transistor (MTE-) étant reliée à la seconde borne d'entrée (IN-),
    dans lequel le deuxième étage d'amplification (TI, TS) comprend des troisième et quatrième transistors MOS (MTI+, MTI-MTS+, MTS-) d'un second type de conductivité,
    dans lequel l'étage à gain unitaire (B) comprend des cinquième et sixième transistors MOS (MB+, MB-) du premier type de conductivité, la grille du cinquième transistor (MB+) étant reliée à la première borne d'entrée (IN+) et la grille du sixième transistor (MB-) étant reliée à la seconde borne d'entrée (IN-),
    dans lequel le troisième étage d'amplification (TI', TS') comprend des septième et huitième transistors MOS (MTI'+, MTI'-, MTS'+, MTS'-) du premier type de conductivité, l'une des bornes de puissance du septième transistor (MTI'+, MTS'+) étant reliée à l'une des bornes de puissance du troisième transistor (MTI+, MTS+) et l'une des bornes de puissance du huitième transistor (MTI'-, MTS'-) étant reliée à l'une des bornes de puissance du quatrième transistor (MTI-, MTS-),
    et dans lequel la grille du troisième transistor (MTS+) est reliée à l'une des bornes de puissance du deuxième transistor (MTE-), la grille du quatrième transistor (MTS-) étant reliée à l'une des bornes de puissance du premier transistor (MTE+), la grille du septième transistor (MTS'+) étant reliée à l'une des bornes de puissance du cinquième transistor (MB+) par l'intermédiaire d'un premier condensateur (C1+) et la grille du huitième transistor (MTS'-) étant reliée à l'une des bornes de puissance du sixième transistor (MB-) par l'intermédiaire d'un deuxième condensateur (C1-) ou dans lequel la grille du troisième transistor (MTS+) est reliée à l'une des bornes de puissance du premier transistor (MTE+), la grille du quatrième transistor (MTS-) étant reliée à l'une des bornes de puissance du deuxième transistor (MTE-), la grille du septième transistor (MTS'+) étant reliée à l'une des bornes de puissance du cinquième transistor (MB+) par l'intermédiaire d'un premier condensateur (C1+) et la grille du huitième transistor (MTS'-) étant reliée à l'une des bornes de puissance du sixième transistor (MB-) par l'intermédiaire d'un deuxième condensateur (C1-) ou dans lequel la grille du troisième transistor (MTI+) est reliée à l'une des bornes de puissance du premier transistor (MTE+), la grille du quatrième transistor (MTI-) étant reliée à l'une des bornes de puissance du deuxième transistor (MTE-), la grille du septième transistor (MTI'+) étant reliée à l'une des bornes de puissance du sixième transistor (MB-) par l'intermédiaire d'un premier condensateur (C3-) et la grille du huitième transistor (MTI'-) étant reliée à l'une des bornes de puissance du cinquième transistor (MB+) par l'intermédiaire d'un deuxième condensateur (C3+).

**5.** Circuit amplificateur selon la revendication 4, dans lequel la grille du septième transistor (MTI'+, MTS'+) est reliée à une borne d'une source de courant (15) par l'intermédiaire d'une première résistance (R3+, R1+) et la grille du huitième transistor (MTI'-, MTS'-) est reliée à la borne de la source de courant (15) par l'intermédiaire d'une deuxième résistance (R3-, R1-).

**6.** Circuit amplificateur selon la revendication 4, comprenant en outre des neuvième et dixième transistors MOS (M12+, M12-) du premier type de conductivité, l'une des bornes de puissance du neuvième transistor (M12+) étant reliée à l'une des bornes de puissance du cinquième transistor (MB+) et l'une des bornes de puissance du dixième transistor (M12-) étant reliée à l'une des bornes de puissance du sixième transistor (MB-), la grille du neuvième transistor (M12+) étant reliée à l'une des bornes de puissance du sixième transistor (MB-) par l'intermédiaire d'un troisième condensateur (C3-) et la grille du dixième transistor (M12-) étant reliée à l'une des bornes de puissance du cinquième transistor (MB+) par l'intermédiaire d'un quatrième condensateur (C3+).

**7.** Circuit amplificateur selon la revendication 6, dans lequel la grille du neuvième transistor (M12+) est reliée à une borne d'une source de courant (15) par l'intermédiaire d'une troisième résistance (R3+) et la grille du dixième transistor (M12-) est reliée à la borne de la source de courant (15) par l'intermédiaire d'une quatrième résistance (R3-).

**8.** Circuit amplificateur selon la revendication 4, dans lequel le premier étage d'amplification (TE) comprend des onzième et douzième transistors MOS (M10+, M10-) du premier type de conductivité, l'une des bornes de puissance du onzième transistor (M10+) étant reliée à l'une des bornes de puissance du premier transistor (MTE+) et l'une des bornes de puissance du douzième transistor (M10-) étant reliée à l'une des bornes de puissance du deuxième transistor (MTE-), le circuit amplificateur comprenant un circuit de polarisation (MB+, C2+, M11+, 16+, MB-, C2-, M11-, 16-) des grilles des onzième et douzième transistors.

**9.** Circuit amplificateur selon la revendication 8, dans lequel le circuit de polarisation comprend des treizième et quatorzième transistors MOS (M11+, M11-) du premier type de conductivité, montés en diode, la grille du treizième transistor (M11+) étant reliée à la grille du onzième transistor (M10+) et la grille du quatorzième transistor (M11-) étant reliée à la grille du douzième transistor (M10-), l'une des bornes de puissance du treizième transistor (M11+) étant reliée à l'une des bornes de puissance du cinquième transistor (MB+) et l'une des bornes de puissance du quatorzième transistor (M11-) étant reliée à l'une des bornes de puissance du sixième transistor (MB-), les bornes de puissance du treizième transistor (M11+) étant reliées entre elles par un cinquième condensateur (C2+) et les bornes de puissance du quatorzième transistor (M11-) étant reliées entre elles par un sixième condensateur (C2-).

**10.** Circuit amplificateur selon la revendication 4, comprenant un quatrième étage d'amplification (TI) entre le premier et le deuxième étages d'amplification (TE, TS), dans lequel le quatrième étage d'amplification (TI) comprend des quinzième et seizième transistors MOS (MTI+, MTI-) du second type de conductivité, la grille du quinzième transistor MOS (MTI+) étant reliée à l'une des bornes de puissance du premier transistor (MTE+) et la grille du seizième transistor MOS (MTI-) étant reliée à l'une des bornes de puissance du deuxième transistor (MTE-), la grille du troisième transistor (MTS+) étant reliée à l'une des bornes de puissance du quinzième transistor (MTI+) et la grille du quatrième transistor (MTS-) étant reliée à l'une des bornes de puissance du seizième transistor (MTI-).

**11.** Circuit intégré comprenant au moins un circuit amplificateur (30 ; 40 ; 50 ; 60 ; 70) selon l'une quelconque des revendications précédentes.

**12.** Convertisseur analogique-numérique, notamment du type pipeline, comprenant au moins un circuit amplificateur (30 ; 40 ; 50 ; 60 ; 70) selon l'une quelconque des revendications 1 à 10.

**13.** Procédé d'amplification d'un premier signal ($V_{IN}$) comprenant :

l'amplification du premier signal par un premier chemin d'amplification dans lequel le premier signal est amplifié successivement plusieurs fois, comprenant au moins une première amplification du premier signal et une deuxième amplification ultérieure fournissant un deuxième signal ($V_{OUT}$) ; et
l'amplification du premier signal par un second chemin d'amplification consistant à fournir un troisième signal correspondant à la recopie à basse impédance du premier signal, et à imposer, aux fréquences supérieures à une fréquence donnée, la phase du deuxième signal à partir du troisième signal.

**Claims**

1. An amplifier circuit (30; 40; 50; 60; 70) comprising:

   a succession of amplification stages (TE, TI, TS) having at least a first amplification stage (TE) receiving a first signal ($V_{IN}$) and a second amplification stage (TI, TS) downstream of the first amplification stage;
   a stage (B) of unity gain capable of receiving the first signal and of providing a second signal corresponding to the low-impedance copy of the first signal; and
   a third amplification stage (TI', TS') having its input connected to the output of the stage of unity gain by a capacitor (C1, C1') and having its output connected to the output of the second amplification stage.

2. The amplifier circuit of claim 1, further comprising:

   a fourth amplification stage (TI) between the first and second amplification stages (TE, TS); and
   a fifth amplification stage (TI') having its input connected to the output of the stage of unity gain by an additional capacitor (C1') and having its output connected to the output of the fourth amplification stage.

3. The amplifier circuit of claim 1, wherein the stage of unity gain (B) comprises at least one MOS transistor assembled as a follower source.

4. The amplifier circuit of claim 1, comprising first and second differential input terminals (IN+, IN-),
   wherein the first amplification stage (TE) comprises first and second MOS transistors (MTE+, MTE-) of a first conductivity type, the gate of the first transistor (MTE+) being connected to the first input terminal (IN+) and the gate of the second transistor (MTE-) being connected to the second input terminal (IN-),
   wherein the second amplification stage (TI, TS) comprises third and fourth MOS transistors (MTI+, MTI-, MTS+, MTS-) of a second conductivity type,
   wherein the stage of unity gain (B) comprises fifth and sixth MOS transistors (MB+, MB-) of the first conductivity type, the gate of the fifth transistor (MB+) being connected to the first input terminal (IN+) and the gate of the sixth transistor (MB-) being connected to the second input terminal (IN-),
   wherein the third amplification stage (TI', TS') comprises seventh and eighth MOS transistors (MTI'+, MTI'-, MTS'+, MTS'-) of the first conductivity type, one of the power terminals of the seventh transistor (MTI'+, MTS'+) being connected to one of the power terminals of the third transistor (MTI+, MTS+) and one of the power terminals of the eighth transistor (MTI'-, MTS'-) being connected to one of the power terminals of the fourth transistor (MTI-, MTS-), and wherein the gate of the third transistor (MTS+) is connected to one of the power terminals of the second transistor (MTE-), the gate of the fourth transistor (MTS-) being connected to one of the power terminals of the first transistor (MTE+), the gate of the seventh transistor (MTS'+) being connected to one of the power terminals of the fifth transistor (MB+) via a first capacitor (C1+) and the gate of the eighth transistor (MTS'-) being connected to one of the power terminals of the sixth transistor (MB-) via a second capacitor (C1-) or wherein the gate of the third transistor (MTS+) is connected to one of the power terminals of the first transistor (MTE+), the gate of the fourth transistor (MTS-) being connected to one of the power terminals of the second transistor (MTE-), the gate of the seventh transistor (MTS'+) being connected to one of the power terminals of the fifth transistor (MB+) via a first capacitor (C1+), and the gate of the eighth transistor (MTS'-) being connected to one of the power terminals of the sixth transistor (MB-) via a second capacitor (C1-) or wherein the gate of the third transistor (MTI+) is connected to one of the power terminals of the first transistor (MTE+), the gate of the fourth transistor (MTI-) being connected to one of the power terminals of the second transistor (MTE-), the gate of the seventh transistor (MTI'+) being connected to one of the power terminals of the sixth transistor (MB-) via a first capacitor (C3-) and the gate of the eighth transistor (MTI'-) being connected to one of the power terminals of the fifth transistor (MB+) via a second capacitor (C3+).

5. The amplifier circuit of claim 4, wherein the gate of the seventh transistor (MTI'+, MTS'+) is connected to a terminal of a current source (I5) via a first resistor (R3+, R1+) and the gate of the eighth transistor (MTI'-, MTS'-) is connected to the terminal of the current source (I5) via a second resistor (R3-, R1-).

6. The amplifier circuit of claim 4, further comprising ninth and tenth MOS transistors (M12+, M12-) of the first conductivity type, one of the power terminals of the ninth transistor (M12+) being connected to one of the power terminals of the fifth transistor (MB+) and one of the power terminals of the tenth transistor (M12-) being connected to one of the power terminals of the sixth transistor (MB-), the gate of the ninth transistor (M12+) being connected to one of the power terminals of the sixth transistor (MB-) via a third capacitor (C3-) and the gate of the tenth transistor (M12-) being connected to one of the power terminals of the fifth transistor (MB+) via a fourth capacitor (C3+).

**7.** The amplifier circuit of claim 6, wherein the gate of the ninth transistor (M12+) is connected to a terminal of a current source (I5) via a third resistor (R3+) and the gate of the tenth transistor (M12-) is connected to the terminal of the current source (I5) via a fourth resistor (R3-).

**8.** The amplifier circuit of claim 4, wherein the first amplification stage (TE) comprises eleventh and twelfth MOS transistors (M10+, M10-) of the first conductivity type, one of the power terminals of the eleventh transistor (M10+) being connected to one of the power terminals of the first transistor (MTE+) and one of the power terminals of the twelfth transistor (M10-) being connected to one of the power terminals of the second transistor (MTE-), the amplifier circuit comprising a circuit (MB+, C2+, M11+, 16+, MB-, C2-, M11-, I6-) for biasing the gates of the eleventh and twelfth transistors.

**9.** The amplifier circuit of claim 8, wherein the bias circuit comprises thirteenth and fourteenth MOS transistors (M11+, M11-) of the first conductivity type, diode-assembled, the gate of the thirteenth transistor (M11+) being connected to the gate of the eleventh transistor (M10+) and the gate of the fourteenth transistor (M11-) being connected to the gate of the twelfth transistor (M10-), one of the power terminals of the thirteenth transistor (M11+) being connected to one of the power terminals of the fifth transistor (MB+) and one of the power terminals of the fourteenth transistor (M11-) being connected to one of the power terminals of the sixth transistor (MB-), the power terminals of the thirteenth transistor (M11+) being interconnected by a fifth capacitor (C2+) and the power terminals of the fourteenth transistor (M11-) being interconnected by a sixth capacitor (C2-).

**10.** The amplifier circuit of claim 4, comprising a fourth amplification stage (TI) between the first and the second amplification stages (TE, TS), wherein the fourth amplification stage (TI) comprises fifteenth and sixteenth MOS transistors (MTI+, MTI-) of the second conductivity type, the gate of the fifteenth MOS transistor (MTI+) being connected to one of the power terminals of the first transistor (MTE+) and the gate of the sixteenth MOS transistor (MTI-) being connected to one of the power terminals of the second transistor (MTE-), the gate of the third transistor (MTS+) being connected to one of the power terminals of the fifteenth transistor (MTI+) and the gate of the fourth transistor (MTS-) being connected to one of the power terminals of the sixteenth transistor (MTI-).

**11.** An integrated circuit comprising at least one amplifier circuit (30; 40; 50; 60; 70) of any of the foregoing claims.

**12.** An analog-to-digital converter, especially of pipeline type, comprising at least one amplifier circuit (30; 40; 50; 60; 70) of any of claims 1 to 10.

**13.** A method for amplifying a first signal ($V_{IN}$) comprising:

the amplification of the first signal through a first amplification path in which the first signal is successively amplified several times, comprising at least a first amplification of the first signal and a second subsequent amplification providing a second signal ($V_{OUT}$); and
the amplification of the first signal through a second amplification path comprising the provision of a third signal corresponding to the low-impedance copying of the first signal, and the imposing, at frequencies greater than a given frequency, of the phase of the second signal from the third signal.

**Patentansprüche**

**1.** Eine Verstärkungsschaltung (30; 40; 50; 60; 70), die Folgendes aufweist:

eine Abfolge von Verstärkungsstufen (TE, TI, TS), die wenigstens eine erste Verstärkungsstufe (TE), die ein erstes Signal ($V_{IN}$) empfängt und
eine zweite Verstärkungsstufe (TI, TS), der ersten Verstärkungsstufe nachgeschaltet, besitzt;
eine Stufe (B) mit Verstärkungsfaktor Eins, die geeignet ist zum Empfangen des ersten Signals und zum Vorsehen eines zweiten Signals, der Kopie mit niedriger Impedanz von dem ersten Signal entsprechend; und
eine dritte Verstärkungsstufe (TI', TS'), deren Eingang mit dem Ausgang von der Stufe mit Verstärkungsfaktor Eins mit einem Kondensator (C1, C1') verbunden ist, und deren Ausgang mit dem Ausgang von der zweiten Verstärkungsstufe verbunden ist.

**2.** Verstärkungsschaltung nach Anspruch 1, die ferner Folgendes aufweist:

eine vierte Verstärkungsstufe (TI) zwischen den ersten und zweiten Verstärkungsstufen (TE, TS); und
eine fünfte Verstärkungsstufe (TI'), deren Eingang verbunden ist mit dem Ausgang von der Stufe mit Verstärkungsfaktor Eins durch einen zusätzlichen Kondensator (C1') und deren Ausgang verbunden ist mit dem Ausgang von der vierten Verstärkungsstufe.

3. Verstärkungsschaltung nach Anspruch 1, wobei die Stufe mit Verstärkungsfaktor Eins (B) wenigstens einen MOS Transistor aufweist, der als Source- bzw. Quellenfolger montiert ist.

4. Verstärkungsschaltung nach Anspruch 1, die erste und zweite differentielle Eingangsanschlüsse (IN+, IN-) aufweist, wobei die erste Verstärkungsstufe (TE) erste und zweite MOS Transistoren (MTE+, MTE-) eines ersten Leitfähigkeitstyps aufweist, wobei das Gatter von dem ersten Transistor (MTE+) verbunden ist mit dem ersten Eingangsanschluss (IN+) und das Gatter von dem zweiten Transistor (MTE-) verbunden ist mit dem zweiten Eingangsanschluss (IN-),
wobei die zweite Verstärkungsstufe (T1, TS) dritte und vierte MOS Transistoren (MTI+, MTI-, MTS+, MTS-) eines zweiten Leitfähigkeitstyps aufweist,
wobei die Stufe mit Verstärkungsfaktor Eins (B) fünfte und sechste MOS Transistoren (MB+, MB-) des ersten Leitfähigkeitstyps aufweist, wobei das Gatter von dem fünften Transistor (MB+) verbunden ist mit dem ersten Eingangsanschluss (IN+) und das Gatter von dem sechsten Transistor (MB-) mit dem zweiten Eingangsanschluss (IN-) verbunden ist,
wobei die dritte Verstärkungsstufe (TI', TS') siebte und achte MOS Transistoren (MTI'+, MTI'-, MTS'+, MTS'-) des ersten Leitfähigkeitstyps aufweist, wobei einer von den Leistungsanschlüssen von dem siebten Transistor (MTI'+, MTS'+) verbunden ist mit einem von den Leistungsanschlüssen von dem dritten Transistor (MTI+, MTS+) und einer von den Leistungsanschlüssen von dem achten Transistor (MTI'-, MTS'-) verbunden ist mit einem von den Leistungsanschlüssen von dem vierten Transistor (MTI-, MTS-),
und wobei das Gatter von dem dritten Transistor (MTS+) verbunden ist mit einem von den Leistungsanschlüssen von dem zweiten Transistor (MTE-), das Gatter von dem vierten Transistor (MTS-) verbunden ist mit einem von den Leistungsanschlüssen von dem ersten Transistor (MTE+), das Gatter von dem siebten Transistor (MTS'+) verbunden ist mit einem von den Leistungsanschlüssen von dem fünften Transistor (MB+) und zwar über einen ersten Kondensator (C1+) und das Gatter von dem achten Transistor (MTS'-) verbunden ist mit einem von den Leistungsanschlüssen von dem sechsten Transistor (MB-) über einen zweiten Kondensator (C1-) oder wobei das Gatter von dem dritten Transistor (MTS+) verbunden ist mit einem von den Leistungsanschlüssen von dem ersten Transistor (MTE+), das Gatter von dem vierten Transistor (MTS-) verbunden ist mit einem von den Leistungsanschlüssen von dem zweiten Transistor (MTE-), das Gatter von dem siebten Transistor (MTS'+) verbunden ist mit einem von den Leistungsanschlüssen von dem fünften Transistor (MB+) und zwar über einen ersten Kondensator (C1+) und das Gatter von dem achten Transistor (MTS'-) verbunden ist mit einem von den Leistungsanschlüssen von dem sechsten Transistor (MB-) und zwar über einen zweiten Kondensator (C1-) oder wobei das Gatter von dem dritten Transistor (MTI+) verbunden ist mit einem von den Leistungsanschlüssen von dem ersten Transistor (MTE+), das Gatter von dem vierten Transistor (MTI-) verbunden ist mit einem von den Leistungsanschlüssen von dem zweiten Transistor (MTE-), das Gatter von dem siebten Transistor (MTI'+) verbunden ist mit einem von den Leistungsanschlüssen von dem sechsten Transistor (MB-) und zwar über einen ersten Kondensator (C3-) und das Gatter von dem achten Transistor (MTI'-) verbunden ist mit einem von den Leistungsanschlüssen von dem fünften Transistor (MB+) und zwar über einen zweiten Kondensator (C3+).

5. Verstärkungsschaltung nach Anspruch 4, wobei das Gatter von dem siebten Transistor (MTI'+, MTS'+) verbunden ist mit einem Anschluss von einer Stromquelle (15) und zwar über einen ersten Widerstand (R3+, R1+) und das Gatter von dem achten Transistor (MTI'-, MTS'-) verbunden ist mit dem Anschluss von der Stromquelle (15) und zwar über einen zweiten Widerstand (R3-, R1-).

6. Verstärkungsschaltung nach Anspruch 4, die ferner aufweist neunte und zehnte MOS Transistoren (M12+, M12-) von dem ersten Leitfähigkeitstyp, wobei einer von den Leistungsanschlüssen von dem neunten Transistor (M12+) verbunden ist mit einem von den Leistungsanschlüssen von dem fünften Transistor (MB+) und einer von den Leistungsanschlüssen von dem zehnten Transistor (M12-) verbunden ist mit einem von den Leistungsanschlüssen von dem sechsten Transistor (MB-), das Gatter von dem neunten Transistor (M12+) verbunden ist mit einem von den Leistungsanschlüssen von dem sechsten Transistor (MB-) und zwar über einen dritten Kondensator (C3-) und das Gatter von dem zehnten Transistor (M12-) verbunden ist mit einem von den Leistungsanschlüssen von dem fünften Transistor (MB+) und zwar über einen vierten Kondensator (C3+).

7. Verstärkungsschaltung nach Anspruch 6, wobei das Gatter von dem neunten Transistor (M12+) verbunden ist mit einem Anschluss von einer Stromquelle (15) und zwar über einen dritten Widerstand (R3+) und das Gatter von dem zehnten Transistor (M12-) verbunden ist mit dem Anschluss von der Stromquelle (15) und zwar über einen vierten Widerstand (R3-).

8. Verstärkungsschaltung nach Anspruch 4, wobei die erste Verstärkungsstufe (TE) elfte und zwölfte MOS Transistoren (M10+, M10-) von dem ersten Leitfähigkeitstyp aufweist, wobei einer von den Leistungsanschlüssen von dem elften Transistor (M10+) verbunden ist mit einem von den Leistungsanschlüssen von dem ersten Transistor (MTE+) und einer von den Leistungsanschlüssen von dem zwölften Transistor (M10-) verbunden ist mit einem von den Leistungsanschlüssen von dem zweiten Transistor (MTE-) wobei die Verstärkerschaltung eine Schaltung (MB+, C2+, M11+, 16+, MB-, C2-, M11-, 16-) aufweist zum Vorspannen der Gatter von den elften und zwölften Transistoren.

9. Verstärkungsschaltung nach Anspruch 8, wobei die Bias- bzw. Vorspannungsschaltung dreizehnte und vierzehnte MOS Transistoren (M11+, M11-) von dem ersten Leitfähigkeitstyp aufweist, und zwar diodenmontiert, wobei das Gatter von dem dreizehnten Transistor (M11+) verbunden ist mit dem Gatter von dem elften Transistor (M10+) und das Gatter von dem vierzehnten Transistor (M11-) verbunden ist mit dem Gatter von dem zwölften Transistor (M10-), einer von den Leistungsanschlüssen von dem dreizehnten Transistor (M11+) verbunden ist mit einem von den Leistungsanschlüssen von dem fünfzehnten Transistor (MB+) und einer von den Leistungsanschlüssen von dem vierzehnten Transistor (M11-) verbunden ist mit einem von den Leistungsanschlüssen von dem sechsten Transistor (MB-), die Leistungsanschlüsse von dem dreizehnten Transistor (M11+) gekoppelt sind durch einen fünften Kondensator (C2+) und die Leistungsanschlüsse von dem vierzehnten Transistor (M11-) gekoppelt sind durch einen sechsten Kondensator (C2-).

10. Verstärkungsschaltung nach Anspruch 4, die eine vierte Verstärkungsstufe (TI) zwischen den ersten und den zweiten Verstärkungsstufen (TE, TS) aufweist, wobei die vierte Verstärkungsstufe (TI) fünfzehnte und sechzehnte MOS Transistoren (MTI+, MTI-) von dem zweiten Leitfähigkeitstyp aufweist, das Gatter von dem fünfzehnten MOS Transistor (MTI+) verbunden ist mit einem von den Leistungsanschlüssen von dem ersten Transistor (MTE+) und das Gatter von dem sechzehnten MOS Transistor (MTI-) verbunden ist mit einem von den Leistungsanschlüssen von dem zweiten Transistor (MTE-), das Gatter von dem dritten Transistor (MTS+) verbunden ist mit einem von den Leistungsanschlüssen von dem fünfzehnten Transistor (MTI+) und das Gatter von dem vierzehnten Transistor (MTS-) verbunden ist mit einem von den Leistungsanschlüssen von dem sechzehnten Transistor (MTI-).

11. Eine integrierte Schaltung, die wenigstens eine Verstärkerschaltung (30; 40; 50; 60; 70) nach irgendeinem der vorhergehenden Ansprüche aufweist.

12. Ein Analog-zu-Digital-Konverter, speziell des Pipeline-Typs, der wenigstens eine Verstärkungsschaltung (30; 40; 50; 60; 70) nach irgendeinem der Ansprüche 1 bis 10 aufweist.

13. Ein Verfahren zum Verstärken eines ersten Signals ($V_{IN}$), wobei das Verfahren Folgendes aufweist:

die Verstärkung von dem ersten Signal durch einen ersten Verstärkungspfad in dem das erste Signal sukzessiv mehrmals verstärkt wird, wenigstens eine erste Verstärkung von dem ersten Signal und eine zweite nachfolgende Verstärkung, ein zweites Signal ($V_{OUT}$) vorsehend, aufweist; und
die Verstärkung von dem ersten Signal durch einen zweiten Verstärkungspfad das Vorsehen eines dritten Signals aufweist, und zwar entsprechend einem Kopieren mit niedriger Impedanz von dem ersten Signal und dem Auferlegen, bei Frequenzen, die größer als eine vorgegebene Frequenz sind, der Phase des zweiten Signals von dem dritten Signal.

Fig 1

Fig 2

Fig 3

Fig 4

Fig 5

Fig 6

Fig 7

Fig 8

Fig 9

Fig 10

Fig 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• FR 2854008

**Littérature non-brevet citée dans la description**

• **MATSUURA T et al.** A 1.2-V Feedforward Amplifier and A/D Converter for Mixed Analog/Digital LSIs. *IEICE Trannsactions on Electronics,* 1996, vol. 79 (12), 1666-1677